# EUROPÄISCHE PATENTSCHRIFT

(11) **EP 1 989 741 B1**
(45) Veröffentlichungstag und Bekanntmachung des Hinweises auf die Patenterteilung: **05.08.2015**
(21) Anmeldenummer: 07721954.1
(22) Anmeldetag: 20.02.2007
(51) Int. Cl.: H01L 35/08, H01L 35/34

(54) **VERFAHREN ZUM HERSTELLEN VON PELTIER-MODULEN**
METHOD FOR THE PRODUCTION OF PELTIER MODULES
PROCEDE POUR PRODUIRE DES MODULES A EFFET PELTIER

(30) Priorität: 01.03.2006 DE 102006009821; 13.03.2006 DE 102006011743
(43) Veröffentlichungstag der Anmeldung: 12.11.2008
(73) Patentinhaber: Curamik Electronics GmbH, 92676 Eschenbach (DE)
(72) Erfinder: SCHULZ-HARDER, Jürgen, 91207 Lauf (DE)
(74) Vertreter: Graf Glück Kritzenberger
(86) Internationale Anmeldenummer: PCT/DE2007/000342
(87) Internationale Veröffentlichungsnummer: WO 2007/098736

(56) Entgegenhaltungen:
- EP-A- 0 821 417
- EP-A- 0 827 215
- EP-A- 1 079 445
- JP-A- 10 074 986
- JP-A- 2002 076 451
- JP-A- 2003 332 644
- JP-A- 2004 273 489
- US-A- 3 301 714
- US-A- 3 707 429
- US-A- 6 127 619
- US-A1- 2004 042 181
- US-A1- 2006 017 170

## Beschreibung

Die Erfindung bezieht sich auf ein Verfahren gemäß Oberbegriff des Patentanspruches 1.

Ein Verfahren mit den Merkmalen des Oberbegriffs des Patentanspruches 1 ist aus der JP 2002 076451 A bekannt.

Aus der US 6 127 619 A ist ferner ein Verfahren zum Herstellen von Peltier-Modulen bekannt, bei dem die Herstellung des einer Vielzahl von Peltier-Elementen aufweisenden Moduls dadurch erfolgt, dass eine Öffnung für jeweils ein Peltier-Element aufweisende Maske auf ein mit Kontaktflächen versehenes Substrat aufgelegt, in die Öffnungen der Maske eine thermoelektrische Paste eingebracht und diese dann gehärtet oder gesintert wird, um thermoelektrische Elemente zu bilden. Nachteilig hierbei ist, dass beim Aushärten oder Sintern der thermoelektrischen Paste thermoelektrische Elemente mit einer unzureichenden Dichte erhalten werden.

Bekannt ist weiterhin ein Verfahren zum Herstellen von Peltier-Modulen (JP 2003 332644 A, JP 2004 273489), bei dem vorgefertigte Peliter-Elemente in ein mit den elektrischen Kontaktflächen vorgefertigtes Gehäuse eingesetzt und mit diesen Kontaktflächen dann durch Plasmasintern verbunden werden. Nachteilig bei diesem Verfahren ist, dass es durch das Einsetzen der vorgefertigten Peltier-Elemente in das Gehäuse eine aufwendige Handhabung erforderlich macht.

Bekannt ist es, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas, bevorzugt Sauerstoff aufweisen. Bei diesem beispielsweise in der US-PS 3744 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z.B. auf ca. 1071 °C;
- Abkühlen auf Raumtemperatur.

Bekannt ist weiterhin das sogenannte Aktivlot-Verfahren (DE 22 13 115;
EP-A-153 618) zum Verbinden von Metallisierungen bildenden Metallschichten oder Metallfolien, insbesondere auch von Kupferschichten oder Kupferfolien mit dem jeweiligen Keramikmaterial. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Aufgabe der Erfindung ist es, ein Verfahren aufzuzeigen, mit dem eine vereinfachte Herstellung von Peltier-Modulen möglich ist. Zur Lösung dieser Aufgabe ist ein Verfahren entsprechend dem Patentanspruch 1 ausgebildet.

Bei der Erfindung erfolgt die Herstellung und die Verbindung der Peltier-Elemente mit den Kontaktflächen dadurch, dass beim Herstellen der Peltier-Elemente durch Sintern diese Elemente gleichzeitig auch auf die Kontaktflächen des Substrats aufgesintert werden. Die Verbindung des jeweiligen Peltier-Elementes an seiner freien Anschlussseite mit der Kontaktfläche erfolgt vorzugsweise durch Sinterbonden, und zwar beispielsweise direkt auf dem die Kontaktfläche bildenden Metallbereich (Metallschicht oder Kupferschicht) oder unter Verwendung wenigstens einer Zwischenschicht zwischen dem Metallbereich und dem jeweiligen Peltier-Element.

Ein Vorteil der Erfindung liegt zum einen in einer wesentlich vereinfachten Fertigung der Peltier-Module, zum anderen aber auch darin, dass die Wärmeleitfähigkeit des Übergangs zwischen dem Peltier-Elementen und den Substraten zumindest an den direkten Verbindungen bzw. an den die Sinterschicht als Verbindungsschicht aufweisenden Verbindungen wesentlich erhöht wird und dadurch die thermischen Eigenschaften bzw. Wirkung des jeweiligen Peltier-Moduls wesentlich verbessert werden.

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in schematischer Darstellung und in Seitenansicht den Aufbau eines Peltier-Moduls;
- Fig. 2 und 3: jeweils in vereinfachter Darstellung den mehrschichtigen Übergang zwischen einem Peltier-Chip und einer an einem Keramiksubstrat gebildeten Kontaktfläche nach dem Stand der Technik;
- Fig. 4 - 13: jeweils verschiedene Übergänge oder Anschlüsse zwischen einer an einem Keramiksubstrat mit Hilfe der DCB-Technik aufgebrachten Kontaktfläche und einem Peltier-Chip gemäß der Erfindung;
- Fig. 14: die Verbindung zwischen den Keramiksubstrat und einem eine Kontaktfläche bildenden Metall- oder Kupferbereich (Kupfer-Pad), hergestellt unter Verwendung des Aktiv-Lötverfahrens;
- Fig. 15: verschiedene Schritte der Herstellung eines Peltier-Moduls;
- Fig. 16: in vergrößerter Darstellung ein zwischen zwei Kontaktflächen angeordnetes Peltier-Element (Peltier-Chip);
- Fig. 17: in vereinfachter Darstellung ein Verfahren zum Herstellen eines Peltier-Elementes und zum gleichzeitigen Verbinden dieses Elementes mit einer Kontaktfläche jeweils durch Sintern in einem gemeinsamen Sinterprozess;
- Fig. 18: in einer Darstellung ähnlich Figur 1 ein Peltier-Modul gemäß einer weiteren möglichen Ausführungsform der Erfindung.

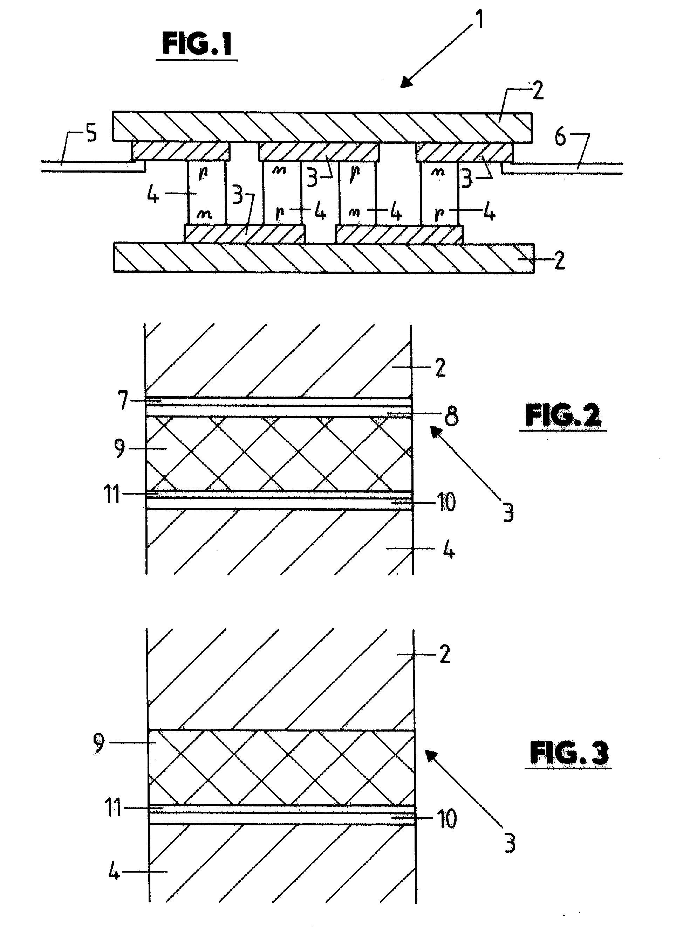

Die Figur 1 zeigt in vereinfachter Darstellung ein Peltier-Modul, welches in an sich bekannter Weise aus zwei plattenförmigen Keramiksubstraten 2 besteht, die an ihren einander zugewandten Oberflächenseiten jeweils mit einer eine Vielzahl von Kontaktflächen 3 bildenden strukturierten Metallisierung versehen sind.

Zwischen den Kontaktflächen 3 sind mehrere Peltier-Chips bzw. Peltier-Elemente 4 vorgesehen, und zwar derart, dass diese Peltier-Elemente 4 in Bezug auf die äußeren Anschlüsse 5 und 6 des Peltier-Moduls elektrisch in Serie liegen. Hierfür sind die Peltier-Elemente 4 mit ihren beiden Anschlussseiten nicht nur jeweils mit einer Kontaktfläche 3 an dem in der Figur 1 oberen und an dem in der Figur 1 unteren Keramiksubstrat verbunden, sondern über jede Kontaktfläche 3 an jedem Keramiksubstrat 2 sind auch einander benachbarte Peltier-Elemente 4 miteinander verbunden, wie dies dem Fachmann bei Peltier-Modulen grundsätzlich bekannt ist.

Die Figur 1 zeigt der einfacheren Darstellung wegen nur eine Reihe mit insgesamt vier Peltier-Elementen 4. Tatsächlich weist ein derartiges Peltier-Modul aber auch senkrecht zur Zeichenebene der Figur 1 eine Vielzahl von Peltier-Elementen 4 in mehreren Reihen und Spalten auf, wobei dann sämtliche Peltier-Elemente 4 elektrisch in Serie zwischen den Anschlüssen 5 und 6 angeordnet sind und dabei hinsichtlich ihrer Polarität so orientiert sind, dass ein Stromfluss durch sämtliche Peltier-Elemente zwischen den Anschlüssen 5 und 6 möglich ist.

Die Figur 2 zeigt eine Verbindung zwischen dem Keramiksubstrat 2 und einer Anschlussseite eines Peltier-Elementes 4, wie sie bei Peltier-Modulen nach dem Stand der Technik üblich ist. Zur Herstellung der Kontaktflächen 3 wird beim Stand der Technik zunächst mittels eines Pastendrucks eine der Anordnung der Kontaktflächen 3 entsprechende strukturierte Schicht aus einer Molybdän, Mangan und/oder Wolfram in Pulverform enthaltenden Paste aufgebracht und bei einer Temperatur über 1100° C in einer reduzierenden Atmosphäre eingebrannt. Die hierdurch erzeugte, entsprechend den Kontaktflächen 3 strukturierte Schicht 7 wird anschließend vernickelt, und zwar beispielsweise in einem chemischen Verfahren. Da allerdings die Schicht 7 für die relativ großen Ströme, mit denen ein Peltier-Modul betrieben wird, keine ausreichend hohe Leitfähigkeit und auch keinen ausreichend großen Querschnitt aufweist, werden auf die vernickelte Schicht 7 mittels eines Weichlots 8 Metallbereiche 9 in Form von Kupferplättchen aufgelötet, die dann unter Verwendung eines Weichlots (Lötschicht 10) mit den Peltier-Elementen 4 verlötet werden. Um eine Diffusion von Kupfer in das jeweilige Peltier-Elemente zu vermeiden, ist noch eine zusätzliche Nickelschicht 11 zwischen der Lotschicht und dem jeweiligen Kupferplättchen 9 erforderlich. Abgesehen davon, dass eine derartige bekannte Verbindung zwischen dem Keramiksubstrat 2 und der jeweiligen, im Wesentlichen von dem Kupferplättchen 9 gebildeten Kontaktfläche 3 sowie die Verbindung zwischen dieser Kontaktfläche und dem Peltier-Element in der Herstellung aufwendig ist, weist diese Verbindung eine unbefriedigende Wärmeleitfähigkeit, wodurch die Wirkung des betreffenden Peltier-Moduls stark reduziert ist.

Die Figur 3 zeigt in schematischer Darstellung den Aufbau einer Verbindung zwischen den Keramiksubstrat 2 und dem jeweiligen Peltier-Element 4 bei einer weiteren bekannten Ausführung, bei der die Kontaktflächen 3 von einer strukturierten Metallisierung gebildet sind, welche mit dem bekannten Direct-Bonding-Verfahren unmittelbar auf das Keramiksubstrat 2 aufgebracht ist. Die Kontaktflächen 3 bildenden Metallisierung ist dabei beispielsweise von jeweils einer Folie aus Kupfer oder einer Kupferlegierung gebildet, die dann nach dem Verbinden mit dem jeweiligen Keramiksubstrat 2 unter Verwendung der üblichen Techniken, beispielsweise unter Verwendung der Maskierungs-Ätztechnik in die einzelnen Kontaktflächen 3 strukturiert wurde. Auch bei dieser bekannten Ausführung sind aber die Peltier-Elemente 4 wieder über die Lotschicht 10 aus Weichlot mit den mit der Nickelschicht 11 versehenen Kontaktflächen 3 verbunden. Durch die DCB-Verbindung zwischen den Kontaktflächen 3 und dem jeweiligen Keramik-Substrat 2 wird zwar eine Verbesserung des thermischen Verhaltens des betreffenden Peltier-Moduls erreicht, nachteilig ist aber weiterhin die Weichlotschicht 10.

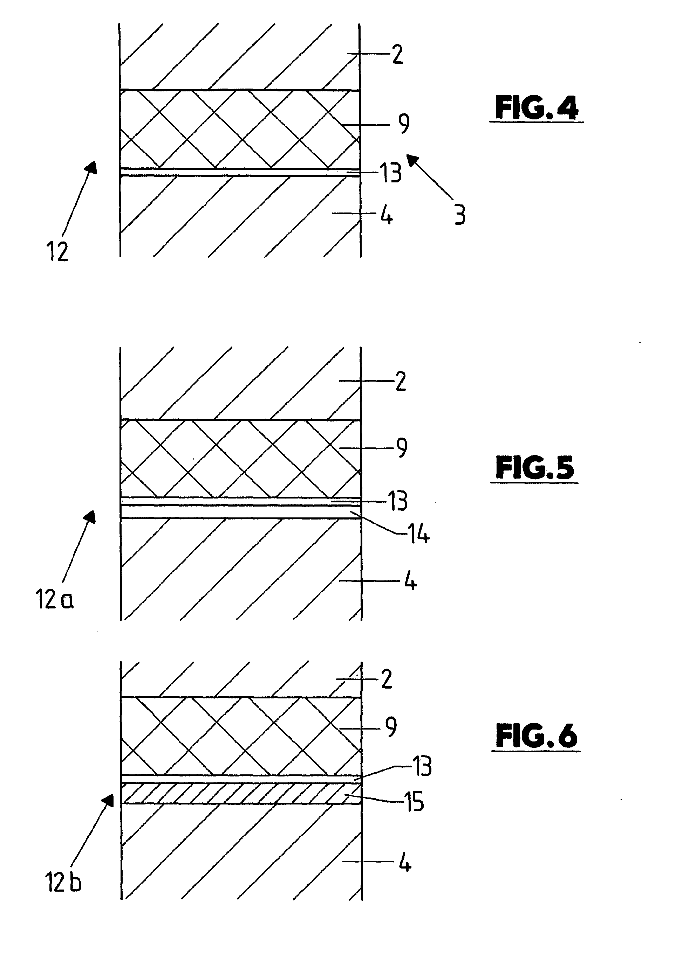

Die Figur 4 zeigt eine in dieser Figur allgemein mit 12 bezeichnete erfindungsgemäße Verbindung zwischen einer Kontaktfläche 3 und einem Peltier-Element 4. Die Kontaktfläche 3 ist bei dieser Ausführungsform von Metallbereichen 9 einer strukturierten Metallisierung, beispielsweise strukturierten Folie aus Kupfer oder einer Kupferlegierung gebildet, die mittels des DCB-Verfahrens flächig mit dem Keramiksubstrat 2 verbunden ist. Das Keramiksubstrat 2 ist beispielsweise eine Aluminiumoxid-Keramik (Al₂O₃), eine Aluminiumoxid-Keramik mit Zusätzen an Zirkonoxid (Al₂O₃ + ZrO₂), eine Aluminiumnitrid-Keramik (AlN) oder eine Siliziumnitrid-Keramik (Si₂N₄). Die Dicke des Keramiksubstrats 2 liegt beispielsweise im Bereich zwischen 0,2 und 1,2 mm. Die Dicke der die Kontaktflächen 3 bildenden Metallisierung liegt beispielsweise im Bereich zwischen 0,1 und 1,0 mm.

Die Kontaktflächen 3 sind mit der Anschlussseite des jeweiligen Peltier-Elementes 4 beispielsweise über eine Zwischenschicht 13 aus Nickel mit einer Dicke im Bereich zwischen 1 und 10 *µ*m (zur Vermeidung einer Diffusion von Kupfer an das Peltier-Element 4) verbunden. Grundsätzlich könnte aber auf die Zwischenschicht 13 verzichtet werden. Die Besonderheit der Verbindung 12 besteht darin, dass sie unmittelbar zwischen dem Peltier-Element 4 und der Kontaktfläche 3 hergestellt ist, und zwar ohne die Verwendung eines Weichlots usw.

Die Figur 5 zeigt als weitere Möglichkeit eine weitere Verbindung 12a, die sich von der Verbindung 12 im Wesentlichen nur dadurch unterscheidet, dass zwischen der Zwischenschicht 13 aus Nickel und dem Peltier-Element 4 noch eine weitere Zwischenschicht 14 aus Gold mit einer Dicke zwischen 0,01 und 1,5 *µ*m vorgesehen ist.

Die Figur 6 zeigt eine Verbindung 12b, die sich von der Verbindung 12 dadurch unterscheidet, dass zwischen der Zwischenschicht 13 aus Nickel und der Anschlussseite des Peltier-Elementes 4 eine Sinterschicht 15 aus einem metallischen Sintermaterial vorgesehen ist, über die das Peltier-Element elektrisch und thermisch mit der jeweiligen Kontaktfläche 3 bzw. mit der Zwischenschicht 13 dieser Kontaktfläche verbunden ist. Die Sinterschicht 15 ist so ausgeführt, dass sie eine Dicke im Bereich zwischen 10 und 20 *µ*m aufweist. Für diese Sinterschicht eignen sich metallische Sintermaterialien, beispielsweise Kupfer, Silber, Legierungen die Kupfer und Silber. Zusätzlich kann das Sintermaterial auch noch weitere Bestandteile enthalten, insbesondere solche, die die Sinterfähigkeit erhöhen und/oder die Sintertemperatur reduzieren. Ein derartiger Bestandteil ist z.B. Zinn.

Die Sinterschicht 15 und damit die Verbindung zwischen dem Peltier-Element 4 und der Kontaktfläche 3 wird beispielsweise durch Aufbringen des pulverförmigen Sintermaterials oder einer dieses Material enthaltenden Dispersion oder Nano-Dispersion auf eine der zu verbinden Flächen und durch anschließendes Erhitzen auf Sintertemperatur und bei einem vorgegebenen Sinterdruck, beispielsweise auf eine Sintertemperatur, die unterhalb der Schmelztemperatur der das jeweilige Peltier-Element bildenden Peltier-Substanz liegt.

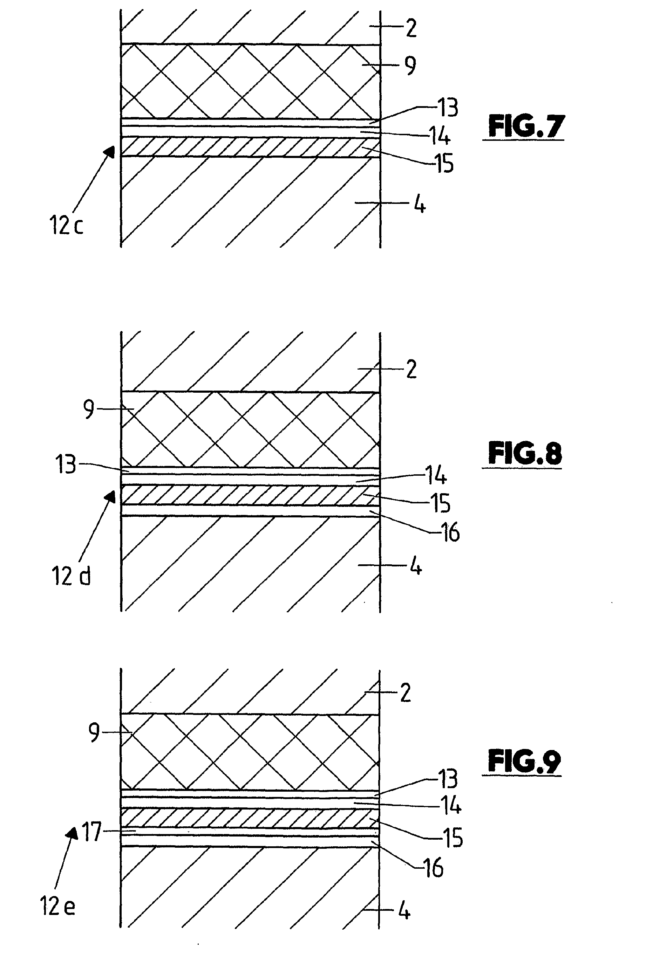

Die Figur 7 zeigt als weitere mögliche Ausführungsform eine Verbindung 12c, die sich von der Verbindung 12b lediglich dadurch unterscheidet, dass zwischen der Zwischenschicht 13 aus Nickel und der Sinterschicht 15 eine Zwischenschicht 14 aus Gold vorgesehen ist, wobei auch bei dieser Ausführungsform die Nickelschicht wiederum eine Schichtdicke im Bereich zwischen 1 - 10 *µ*m und die Goldschicht eine Dicke im Bereich zwischen 0,01 und 1,5 *µ*m aufweisen.

Die Figur 8 zeigt als weitere Ausführungsform eine Verbindung 12d, die sich von der Verbindung 12c dadurch unterscheidet, dass zwischen der Sinterschicht 15 und dem Peltier-Element 4 eine weitere Zwischenschicht 16 aus Nickel vorgesehen ist, die beispielsweise eine Dicke zwischen 1 und 10 *µ*m besitzt.

Die Figur 9 zeigt eine Verbindung 12e, die sich von der Verbindung 12d dadurch unterscheidet, dass zwischen der Zwischenschicht 16 aus Nickel und der Sinterschicht 15 eine Zwischenschicht 17 aus Gold vorgesehen ist, die beispielsweise eine Dicke im Bereich zwischen 0,01 und 1,5 *µ*m besitzt.

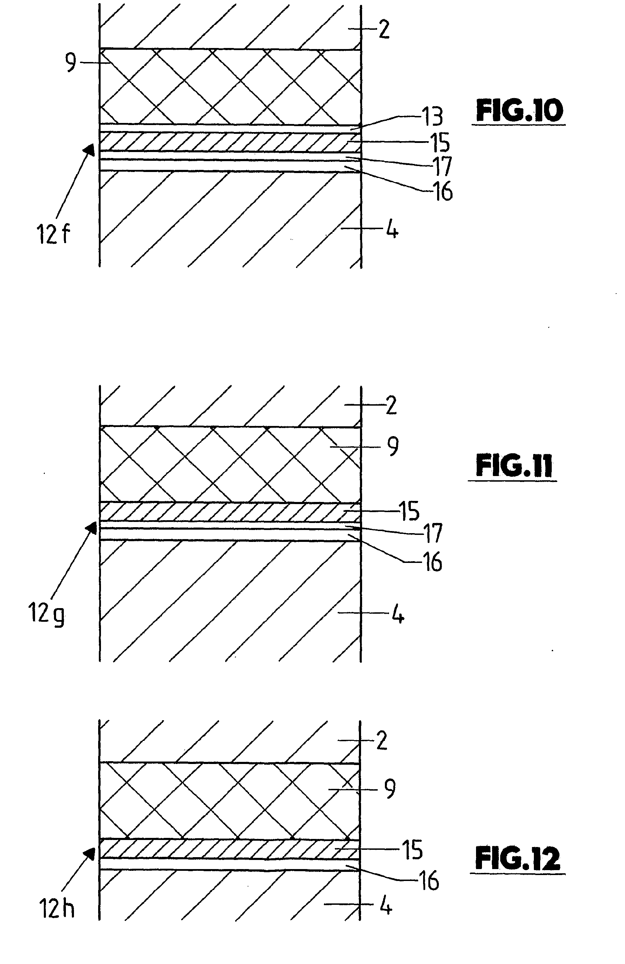

Die Figur 10 zeigt eine Verbindung 12f, die der Verbindung 12e entspricht, wobei allerdings auf die Zwischenschicht 14 aus Gold verzichtet ist.

Die Figur 11 zeigt eine Verbindung, bei der auch auf die Zwischenschicht 13 aus Nickel verzichtet ist, die Sinterschicht 15 also unmittelbar an die jeweilige Kontaktfläche 3 bzw. an den diese bildenden Metallbereich 9 anschließt.

Die Figur 12 zeigt eine Verbindung 12h, die sich von der Verbindung 12g dadurch unterscheidet, dass auch auf die Zwischenschicht 17 aus Gold verzichtet ist.

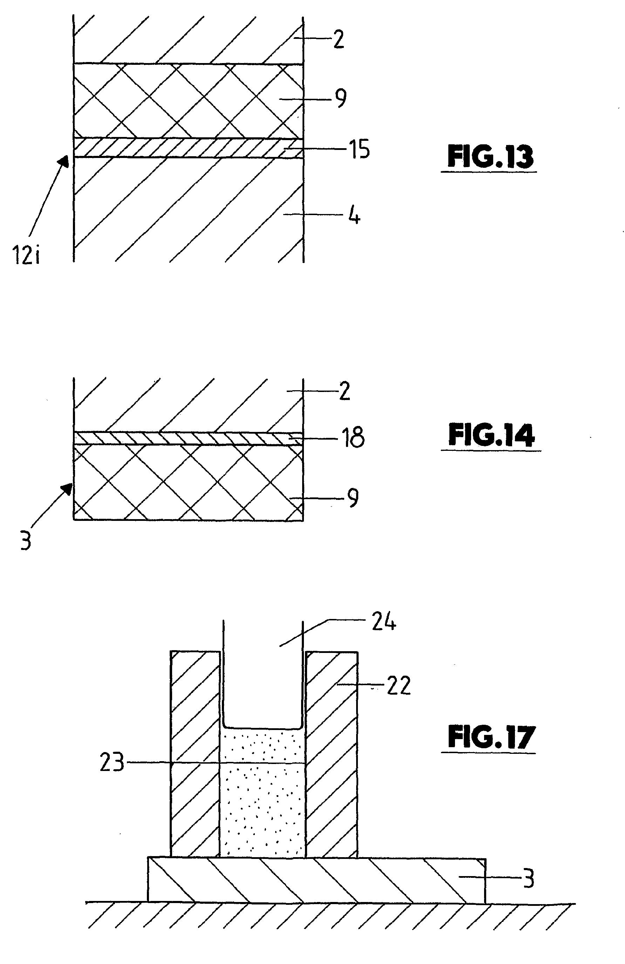

Die Figur 13 zeigt schließlich eine Verbindung 12i, bei der die jeweilige Kontaktfläche 3 über die Sinterschicht 15 direkt an das Peltier-Element 4 anschließt.

Während bei den Ausführungsformen der Figuren 4 - 13 die Kontaktflächen 3 bzw. die Metallbereiche 9 jeweils von der strukturierten, mit dem DCB-Verfahren auf das jeweilige Keramiksubstrat 2 aufgebrachten Metallisierungen 3 gebildet sind, besteht entsprechend Figur 14 auch die Möglichkeit, die Kontaktflächen 3 bzw. Metallbereiche 9 bildende Metallisierung auch durch Aktivlöten, d.h. über eine Aktivlot-Schicht 18 mit dem jeweiligen Keramiksubstrat zu verbinden. Die Aktivlotschicht 18 enthält dann in der dem Fachmann bekannten Weise eine als Hartlot geeignete Legierung, beispielsweise eine Kupfer-Silber-Legierung mit einer Aktivlot-Komponente, beispielsweise Titan, Hafnium, Zirkonium. Die Dicke der Aktivlotschicht liegt dann z.B. im Bereich zwischen 1 und 20 *µ*m. Die durch Aktivlöten mit dem jeweiligen Keramiksubstrat 2 verbundenen Kontaktflächen 3 können dann ebenfalls über die unterschiedlichsten Verbindungen, beispielsweise über die Verbindungen 12, 12a - 12i mit dem jeweiligen Peltier-Element verbunden werden.

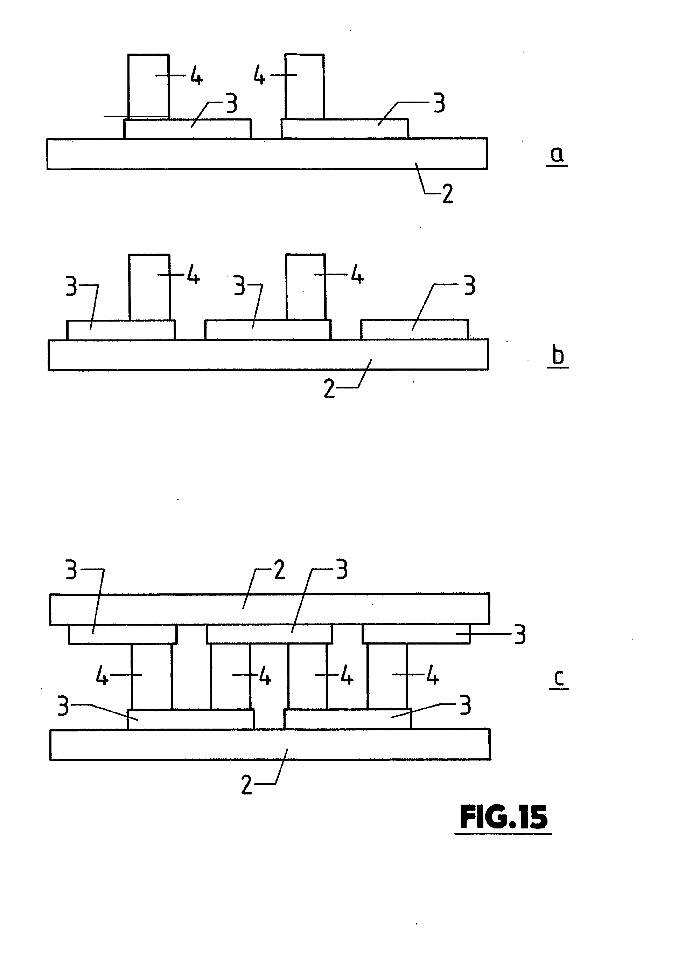

Mehr im Detail erfolgt die Herstellung der Peltier-Module 1 mit den vorgeschriebenen Übergängen 12, 12a - 12i z.B. entsprechend der Figur 15 in der Weise, dass ein in geeigneter Weise hergestellter Peltier-Wafer in einzelne Peltier-Elemente 4 zerteilt wird und diese Elemente dann an den Kontaktflächen 3 der Keramiksubstrate 2 über eine der Verbindungen 12 bzw. 12a - 12i derart befestigt werden, dass über die betreffende Verbindung an jeder Kontaktfläche 3 ein Peltier-Element 4 vorgesehen ist, und zwar an sämtlichen Kontaktflächen 3 jeweils eines Keramik-Substrats 2 jeweils in der selben elektrischen Orientierung bzw. mit dem selben Pol. Jeweils zwei so mit den Peltier-Elementen 4 vorbestückte und in der Figur 15 in den Positionen a und b dargestellte Keramik-Substrate werden dann entsprechend der Position c der Figur 15 aufeinander gesetzt, so dass die Peltier-Elemente 4 über die Kontaktflächen 13 elektrisch in Serie liegen. Durch eine auf die freien Enden oder Anschlussseiten der Peltier-Elemente 4 aufgebrachte Lotschicht 19 werden die Peltier-Elemente 4 an jedem Keramik-Substrat 2 mit ihrer bis dahin freiliegenden, nicht kontaktierten Anschlussseiten mechanisch sowie elektrisch mit jeweils einer Kontaktfläche 3 an dem jeweils anderen Keramik-Substrat 2 verbunden. Zwischen der Lotschicht 15 und dem Peltier-Element 4 ist wenigstens eine Zwischenschicht 20, beispielsweise eine Nickelschicht vorgesehen. Wenigstens eine weitere Zwischenschicht 21, beispielsweise eine Nickelschicht ist zwischen der Lotschicht 15 und der jeweiligen Kontaktfläche 3 vorgesehen.

Das Aufbringen der Zwischenschichten 20 sowie weiterer Zwischenschichten, beispielsweise der Zwischenschichten 13, 16 und 17 auf die Peltier-Elemente 4 erfolgt beispielsweise nach dem Zertrennen des Peltier-Wafers in die einzelnen Peltier-Elemente 4 unter Verwendung geeigneter Verfahren, beispielsweise elektrolytisch und/oder durch chemisches Abscheiden. U.a. bei Zwischenschichten aus Silber besteht die Möglichkeit, diese Schichten durch Aufbringen einer das Material der Zwischenschichten enthaltenden Dispersion, beispielsweise Nano-Dispersion oder einer entsprechenden Paste zu erzeugen, und zwar z.B. durch Drucken unter Verwendung von Sieben, Druckmasken oder Schablonen.

Die Herstellung der Keramiksubstrate erfolgt bei Ausführungen der Figuren 4 - 13 in der Weise, dass mit Hilfe des DCB-Verfahrens auf wenigstens einer Oberflächenseite der jeweiligen Keramikschicht bzw. des jeweiligen Keramiksubstrates 2 eine Metallisierung in Form einer Kupferfolie aufgebracht und diese anschließend durch eine geeignete Technik, beispielsweise eine Maskier- und Ätztechnik in die einzelnen die Kontaktflächen 3 bzw. Pads bildenden Metallbereiche 9 strukturiert wird.

Das Aufbringen der einzelnen Zwischenschichten, z.B. der Zwischenschichten 13 und 14 erfolgt beispielsweise galvanisch und/oder durch chemisches Abscheiden. U.a. bei Zwischenschichten aus Silber besteht die Möglichkeit, diese Schichten durch Aufbringen einer das Material der Zwischenschichten enthaltenden Dispersion, beispielsweise Nano-Dispersion oder einer entsprechenden Paste zu erzeugen, und zwar z.B. durch Drucken unter Verwendung von Sieben, Druckmasken oder Schablonen.

Bei der Ausführung der Figur 14 erfolgt nach dem Aufbringen der die Kontaktflächen 3 bildenden Metallisierung in Form einer Metall- oder Kupferfolie unter Verwendung des Aktivlötens bzw. der Aktivlotschicht 18 wiederum mit geeigneten Maßnahmen (z.B. Maskierungs- und Ätztechnik) das Strukturieren der Metallisierung in die einzelnen die Kontaktflächen 3 bildenden Metallbereiche 9, worauf dann auch auf diese Metallbereiche 9 ggs. ein oder mehrere Zwischenschichten aufgebracht werden, und zwar wiederum durch galvanisches oder chemisches Abscheiden und/oder Aufbringen einer das Metall der Zwischenschicht in Pulverform enthaltenden Dispersion (beispielsweise auch Nano-Dispersion) oder Paste durch Aufdrucken, beispielsweise unter Verwendung von Sieben oder Druckmasken oder unter Verwendung von Schablonen.

Das Fügen der an den Füge- oder Verbindungsflächen bzw. Anschlussseiten ohne Zwischenschicht oder aber mit einer oder mehreren Zwischenschichten versehenen Peltier-Elemente 4 auf den Kontaktflächen 3, die ebenfalls ohne eine Zwischenschicht oder aber mit einer oder mehreren Zwischenschichten versehen sind, erfolgt bei den Ausführungen der Figuren 6 - 13 jeweils über die Sinterschicht 15. Hierfür wird auf wenigstens eine der zu verbindenden Flächen das metallische Sintermaterial in Pulverform, beispielsweise als Dispersion oder Nano-Dispersion aufgebracht.

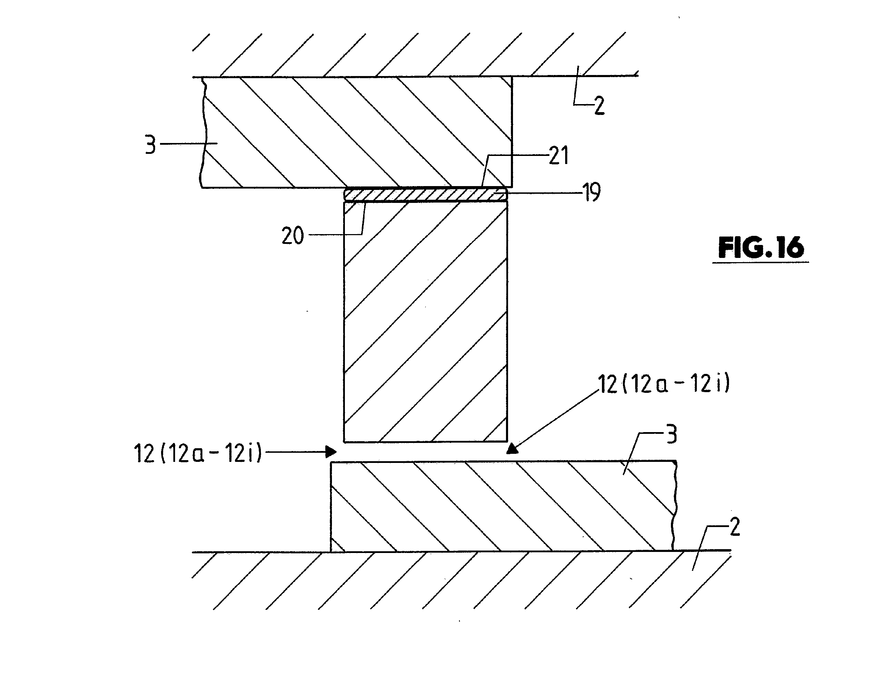

Anschließend wird bei Sintertemperatur und unter Sintertemperatur die verbindende Sinterschicht 15 erzeugt.
Die Sintertemperatur liegt dabei unter der Schmelztemperatur des Materials der Peltier-Elemente 4, beispielsweise um 30 bis 50° C unter dieser Schmelztemperatur, beträgt aber wenigstens eine 120° C. Grundsätzlich besteht auch die Möglichkeit, dieses Sinterbonden in einer Vorsinterphase zunächst ohne Druck auszuführen, und zwar bis sich aus dem Sintermaterial eine Schicht mit geschlossenen Poren ausgebildet hat, und dass dann ein Sintern bei Sintertemperatur und z.B. mit erhöhtem Sinterdruck erfolgt. Die jeweilige Sinterschicht wird so erzeugt, dass ihre Dicke beispielsweise im Bereich zwischen 10 und 200 *µ*m liegt. Besonders geeignet für das Sinterbonden bzw. für die Erzeugung der Sinterschicht 15 ist das sogenannte Spark-Plasma-Sinterverfahren, bei dem durch einen Stromfluss durch das Sintermaterial die erforderliche Sintertemperatur erzeugt wird.
Vorstehend wurde in Zusammenhang mit den Figuren 15 und 16 davon ausgegangen, dass die Peltier-Elemente 4 jeweils nur an einer Anschlussfläche über die Sinterschicht 15 bzw. die Sinterverbindung mit einer Kontaktfläche 3 eines Keramiksubstrates 2 verbunden sind, während die Verbindung der anderen Anschlussseite mit der entsprechenden Kontaktfläche 3 über die Lotschicht 19, beispielsweise Weich- oder Hartlotschicht oder auch über eine entsprechende Sinterverbindung (Sinterbonden) erfolgt. Bei entsprechender Ausgestaltung des Verfahrens ist es selbstverständlich auch möglich, beide Anschlussseiten jedes Peltier-Elementes ggs. unter Verwendung von Zwischenschichten über eine Sinterverbindung mit den Kontaktflächen 3 zu verbinden.
Die Figur 17 zeigt in schematischer Darstellung ein Verfahren, bei dem die Peltier-Elemente 4 nicht vorgefertigt und erst dann die Keramiksubstrate 2 an ihren Kontaktflächen 3 in der vorbeschriebenen Weise mit den Peltier-Elementen 4 bestückt, und zwar beispielsweise unter Verwendung von Schablonen oder Masken, sondern bei diesem Verfahren werden die Peltier-Elemente 4 werden durch Sintern unter Einwirkung von Hitze und Druck und erzeugt und dabei gleichzeitig auf die Kontaktflächen 3 aufgesintert. Die Herstellung des jeweiligen Peltier-Elementes 4 und das Verbinden dieses Elementes mit einer Kontaktfläche 3 erfolgen also durch Sintern in ein und dem selben Arbeitsgang. Verwendet wird bei diesem Verfahren eine Maske 22, die eine Vielzahl von Öffnungen 23 aufweist, von denen jede eine Form zum Herstellen eines Peltier-Elementes 4 bildet. Die Maske 22 wird auf jeweils ein mit den Kontaktflächen 3 vorbereitetes Keramiksubstrat 2 derart aufgesetzt, dass sich jede Öffnung 23 dort befindet, wo an die Kontaktfläche 3 ein Peltier-Element 4 anschließen soll.

Die Öffnungen 23 werden mit einer für die Herstellung von Peltier-Elementen geeigneten Pulvermischung gefüllt, beispielsweise mit einer Mischung aus Zn und Sb, aus Pb und Te, aus Bi und Te, aus Ag, Pb, Sb und Te oder aus Pb, Te und Se. Mit Hilfe von in die Öffnungen 23 passend eingeführten Stempeln 24, die beispielsweise Bestandteil eines nicht dargestellten Stempelwerkzeugs sind, wird die in die Öffnungen 23 eingebrachte Pulvermischung mit Sinterdruck beaufschlagt und unter Einwirkung von Hitze durch Sintern in das jeweilige Peltier-Element 4 geformt und dieses zugleich auf die jeweilige Kontaktfläche 3 aufgesintert bzw. mit dieser durch Sinterbonden verbunden. Besonders geeignet für dieses Verfahren ist wiederum das sogenannte Spark-Plasma-Sinterverfahren, bei dem dann durch den beispielsweise zwischen dem jeweiligen Stempel 4 und der Kontaktfläche 3 fließenden Strom die erforderliche Sintertemperatur erzeugt wird.

Auch bei diesem Verfahren sind die Kontaktflächen 3 entweder von den Metallbereichen 9 oder Kupferschichten ohne Zwischenschicht gebildet oder mit einer oder mehreren Zwischenschicht versehen. Mit diesem Verfahren sind beispielsweise die Verbindungen 12 und 12a gefertigt. Die Herstellung und das Sinterbonden der einzelnen Peltier-Elemente 4 erfolgt wiederum entsprechend der Figur 15 derart, dass jedes Peltier-Element 4 mit einer Anschlussseite an einer Kontaktfläche 3 eines Keramik-Substrats 2 vorgesehen ist und von dieser Kontaktfläche wegsteht. Über eine Lotschicht 19, beispielsweise Weich- oder Hartlotschicht oder auch eine entsprechende Sinterverbindung werden dann entsprechend der Position c der Figur 15 die bis dahin freien Anschlussende der Peltier-Elemente eines jeden Keramiksubstrats 2 mit den Kontaktflächen 3 eines weiteren Keramiksubstrats 2 verbunden.

Bei Anwendung einer speziellen Maskierungs- und Fülltechnik ist es auch möglich, auf den Kontaktflächen 3 eines der beiden Keramiksubstrate des herzustellen Peltier-Moduls sämtliche Peltier-Elemente durch Sintern zu Formen und mit den Kontaktflächen 3 zu verbinden, so dass dann in einem zweiten Verfahrensschritt nach dem Abkühlen der Peltier-Elemente deren freiliegende Anschlussseiten mit den Kontaktflächen 3 an dem zweiten Keramiksubstrat 2 des jeweiligen Peltier-Moduls elektrisch und mechanisch verbunden werden, und zwar beispielsweise wiederum um eine Weichlot- oder Hartlotschicht oder durch eine Sinterschicht.

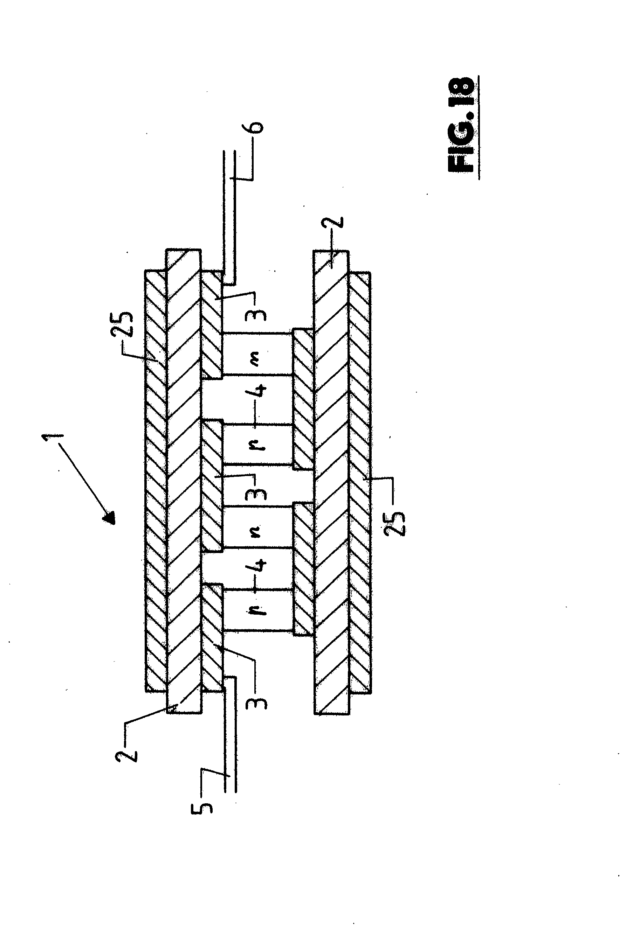

Speziell für das Sinterbonden, d.h. bei Verbindungen, die die Verbindungen 12b - 12i eine Sinterschicht 15 aufweisen, kann es sinnvoll sein, dass das jeweilige Keramiksubstrat 2 an der den Peltier-Elementen 4 abgewandten Oberflächenseite mit einer zusätzlichen Metallschicht 25, beispielsweise mit einer Kupferschicht versehen ist, die dann u.a. die Festigkeit und Zuverlässigkeit der Keramiksubstrate 2 während des Sintervorgangs erhöht, wie dies in der Figur 18 für eine weitere Ausführungsform dargestellt ist, bei die Peltier-Elemente 4 abwechseld aus einem Material mit n-Dotierung und mit p-Dotierung bestehen und nicht, wie bei der Ausführung der Figur 1, jeweils aus einem n-dotierten und einem p-dotierten Abschnitt.

Die Erfindung wurde voranstehend an verschiedenen Ausführungsbeispielen beschrieben. Es versteht sich, dass zahlreiche Änderungen sowie Abwandlungen möglich sind, ohne dass dadurch der der Erfindung zugrunde liegende Erfindungsgedanke verlassen wird.

### Bezugszeichenliste

- 1: Peltier-Modul
- 2: Keramik-Substrat
- 3: Kontaktfläche
- 4: Peltier-Element oder -chip
- 5, 6: elektrischer Anschluss des Peltier-Moduls
- 7: Metallisierung
- 8: Weichlotschicht
- 9: Metallbereich (Metall- oder Kupferpad)
- 10: Weichlotschicht
- 11: Nickelschicht
- 12, 12a - 12i: Verbindung zwischen Peltier-Element 4 und Kontaktfläche 3 bzw. Metallpad der Kontaktfläche 3
- 13: Zwischenschicht aus Nickel
- 14: Zwischenschicht aus Silber und/oder Gold
- 15: Sinterschicht
- 16: Nickelschicht
- 17: Zwischenschicht aus Selber und/oder Gold
- 18: Aktivlotschicht
- 19: Weichlotschicht
- 20, 21: Zwischenschicht aus Nickel, Silber oder Gold
- 22: Maske
- 23: Öffnung
- 24: Einzelstempel eines Stempelwerkzeugs
- 25: Metall- oder Kupferschicht

## Patentansprüche

1. Verfahren zum Herstellen von Peltier-Modulen (1) mit mehreren zwischen wenigstens zwei Keramiksubstraten (2) angeordneten Peltier-Elementen (4), wobei die Keramiksubstrate (2) zumindest an ihren den Peltier-Elementen (4) zugewandten Seiten aus einem elektrisch isolierenden Material bestehen und an diesen Seiten mit von metallischen Bereichen (9) gebildeten Kontaktflächen (3) versehen sind, mit denen die Peltier-Elemente (4) bei der Herstellung mit Anschlussflächen an einer Anschlussseite über eine Sinterverbindung (15) oder durch Sinterbonden mit Kontaktflächen (3) verbunden werden, wobei die Herstellung der Peltier-Elemente (4) und das Sinterbonden in einem gemeinsamen Sinterprozess erfolgen, und zwar unter Verwendung einer Maske (22) mit einer Vielzahl von Öffnungen (23), die jeweils auf ein mit den Kontaktflächen (3) versehenes Keramiksubstrat (2) derart aufgesetzt wird, dass sich jede Öffnung (23) über einer Kontaktfläche (3) befindet, und mit einem für die Herstellung der Peltier-Elemente geeigneten Material gefüllt werden, aus dem anschließend die Peltier-Elemente durch Sintern geformt werden, wobei das für die Herstellung der Peltier-Elemente geeignete Material als Pulvermischung in die Öffnungen (23) eingebracht wird, und wobei das Sintern und Sinterbonden unter Anwendung eines Spark-Plasma-Sinterverfahrens bei einem Sinterdruck erfolgt, **dadurch gekennzeichnet,**
**dass** jedes Peltier-Element (4) durch Weichlöten oder Hartlöten an seiner bis dahin freien Anschlussseite mit einer Kontaktfläche eines zweiten Keramiksubstrats (2) verbunden wird und dass das Sintern und Sinterbonden bei einem Sinterdruck im Bereich zwischen etwa 10 und 300 bar erfolgt.

2. Verfahren nach Anspruch 1, **dadurch gekennzeichnet, dass** als Pulvermischung eine Mischung aus Zn und Sb, aus Pb und Te, aus Bi und Te, aus Ag, Pb, Sb und Te oder aus Pb, Te und Se verwendet wird.

3. Verfahren nach einem der vorhergehenden Ansprüche, **dadurch gekennzeichnet, dass** das Sintern oder Sinterbonden bei einer Sintertemperatur unter der Schmelztemperatur des Materials der Peltier-Elemente (4) erfolgt, beispielsweise bei einer Sintertemperatur über 100° C und etwa 30 bis 50° C unter der Schmelztemperatur des Materials der Peltier-Elemente.

4. Verfahren nach einem der Ansprüche 1 bis 3, **dadurch gekennzeichnet, dass** das Sinterbonden in dem weiteren Verfahrensschritt unter Verwendung eines metallischen Sintermaterials, beispielsweise unter Verwendung von Kupfer, Silber und/oder einer Kupfer-Silber-Legierung erfolgt.

5. Verfahren nach einem der Ansprüche 1 bis 4, **dadurch gekennzeichnet, dass** das Sintermaterial für das Sinterbonden mit einer Dicke im Bereich zwischen 10 - 200 *µ*m aufgebracht wird.

6. Verfahren Anspruch 4 oder 5, **dadurch gekennzeichnet, dass** als metallisches Sintermaterial ein solches in Form eines Pulvers, vorzugsweise in Form einer das Sintermaterial in Pulverform oder in nano-disperser Form enthaltenden Dispersion oder Paste aufgebracht wird, und/oder ein solches mit Zusätzen, insbesondere mit die Sintertemperatur und/oder den Sinterdruck reduzierenden Zusätze, beispielsweise Zinn verwendet wird,

7. Verfahren nach einem der vorhergehenden Ansprüche, **dadurch gekennzeichnet, dass** das Sinterbondung unmittelbar auf die die Kontaktflächen (3) bildenden Metallbereiche (9) erfolgt.

8. Verfahren nach einem der vorhergehenden Ansprüche, **dadurch gekennzeichnet, dass** vor dem Sinterbonden die die Kontaktflächen (3) bildenden Metallbereiche (9) und/oder die Peltier-Elemente (4) an ihren freien Anschlussseiten mit wenigstens einer Zwischenschicht (13, 14, 16, 17) aus Metall, beispielsweise einer Zwischenschicht aus Nickel und/oder Silber und/oder Gold versehen werden, wobei die Zwischenschicht z.B. durch galvanisches und/oder chemisches Abscheiden und/oder durch Aufbringen des die Zwischenschicht bildenden Materials mittels einer Paste oder einer Dispersion, beispielsweise Nano-Dispersion erfolgt.

9. Verfahren nach einem der vorhergehenden Ansprüche, **dadurch gekennzeichnet, dass** als Keramiksubstrat (2) ein aus Aluminiumoxid hergestelltes Keramiksubstrat, ein aus Aluminiumoxid hergestelltes Keramiksubstrat mit Zusätzen an Zirkonoxid, ein aus Aluminiumnitrid hergestelltes Keramiksubstrat oder ein aus Siliziumnitrid hergestelltes Keramiksubstrat verwendet wird.

10. Verfahren nach einem der vorhergehenden Ansprüche, **dadurch gekennzeichnet, dass** die Kontaktflächen (3) bildenden Metallbereiche (9) durch Aufbringen und Strukturieren einer Metallisierung, beispielsweise in Form einer Metall- oder Kupferfolie gebildet werden, wobei das Aufbringen der die Metallisierung bildenden Metall- oder Kupferfolie z.B. unter Verwendung des Direct-Bondens oder des Aktivlotverfahrens erfolgt.

## Claims

1. A method for producing Peltier modules (1) with a plurality of Peltier elements (4) arranged between at least two ceramic substrates (2), wherein the ceramic substrates (2) are made of an electrically insulating material, at least on their sides facing the Peltier elements (4) and are provided on these sides with contact areas (3) formed by metallic regions (9), with which the Peltier elements (4) are connected during production with connection faces to a connection side via a sintered connection (15) or by sinter-bonding with contact faces (3), wherein production of the Peltier elements (4) and sinter-bonding take place in a joint sintering process, namely using a mask (22) having a plurality of openings (23), each of which is placed on a ceramic substrate (2) provided with the contact faces (3) in such a manner that each opening (23) is located above a contact face (3), and they are filled with a suitable material for producing Peltier elements, from which the Peltier elements are then formed by sintering, wherein the material suitable for producing the Peltier elements is introduced into the openings (23) as a powder mixture and wherein the sintering and sinter-bonding takes place using a spark plasma sintering method at a sintering pressure, **characterized in that** each Peltier element (4) is connected by soft-soldering or hard-soldering to its hitherto free connection side with a contact face of a second ceramic substrate (2) and that the sintering and sinter-bonding takes place at a sintering pressure in the region of between roughly 10 and 300 bar.

2. The method according to claim 1, **characterized in that** a mixture of Zn and Sb, Pb and Te, Bi and Te, Ag, Pb, Sb and Te or Pb, Te and Se is used.

3. The method according to one of the preceding claims, **characterized in that** the sintering or sinter-bonding takes place at a sintering temperature below the melting temperature of the material of the Peltier elements (4), for example at a sintering temperature of over 100 °C and roughly 30 to 50 °C below the melting temperature of the material of the Peltier elements.

4. The method according to one of claims 1 to 3, **characterized in that** the sinter-bonding in the further process step takes place using a metallic sintering material, for example using copper, silver and/or a copper-silver alloy.

5. The method according to one of claims 1 to 4, **characterized in that** the sintering material for the sinter-bonding is applied with a thickness in the region of between 10 and 200 µm.

6. The method according to claim 4 or 5, **characterized in that** a sintering material in the form of a powder, preferably in the form of a dispersion or paste containing the sintering material in powder form or in a nano-disperse form is applied as the metallic sintering material and/or a material of this kind with additives, in particular with additives reducing the sintering temperature and/or the sintering pressure, such as tin, for example, is used.

7. The method according to one of the preceding claims, **characterized in that** the sinter-bonding takes place directly on the metal regions (9) forming the contact faces (3).

8. The method according to one of the preceding claims, **characterized in that** prior to the sinter-bonding, the metal regions (9) forming the contact faces (3) and/or the Peltier elements (4) are provided at their free connection sides with at least one intermediate layer (13, 14, 16, 17) of metal, for example an intermediate layer of Nickel and/or silver and/or gold, wherein the intermediate layer occurs e.g. through galvanic and/or chemical separation and/or through application of the material forming the intermediate layer by means of a paste or a dispersion, for example a nano-dispersion.

9. The method according to one of the preceding claims, **characterized in that** a ceramic substrate made of aluminium oxide, a ceramic substrate made of aluminium oxide with additives of zirconium oxide, a ceramic substrate made of aluminium nitride or a ceramic substrate made of silicon nitride is used as the ceramic substrate (2).

10. The method according to one of the preceding claims, **characterized in that** the metal regions (9) forming the contact faces (3) are formed by the application and structuring of a metallization, for example in the form of a metal or copper film, wherein the application of the metal or copper film forming the metallization takes place using direct bonding or the active-soldering method, for example.

## Revendications

1. Procédé pour la fabrication de modules Peltier (1) avec plusieurs éléments Peltier (4) disposés entre au moins deux substrats en céramique (2), dans lequel les substrats en céramique (2) se composent, au moins sur leurs côtés tournés vers les éléments Peltier (4), d'un matériau d'isolation électrique et sont munis, sur ces côtés, de surfaces de contact (3) formées par des zones métalliques (9), avec lesquelles les éléments Peltier (4) sont reliés lors de la fabrication, avec des surfaces de raccordement sur un côté de raccordement, via une liaison frittée (15) ou par fixation par frittage, à des surfaces de contact (3), dans lequel la fabrication des éléments Peltier (4) et la fixation par frittage s'effectuent lors d'un processus de frittage commun, à savoir en utilisant un masque (22) avec une pluralité d'ouvertures (23), lequel est respectivement posé sur un substrat en céramique (2) muni des surfaces de contact (3) de manière à ce que chaque ouverture (23) se trouve au-dessus d'une surface de contact (3) et soit remplie avec un matériau adéquat pour la fabrication des éléments Peltier à partir duquel les éléments Peltier sont ensuite formés par frittage, dans lequel le matériau adéquat pour la fabrication des éléments Peltier est introduit par les ouvertures (23) en tant que mélange pulvérulent, et dans lequel le frittage et la fixation par frittage s'effectuent en utilisant un procédé de frittage spark-plasma avec une pression de frittage,
**caractérisé en ce que** chaque élément Peltier (4) est relié par brasage tendre ou brasage dur, au niveau de son côté de raccordement libre jusque-là, à une surface de contact d'un deuxième substrat en céramique (2) et **en ce que** le frittage et la fixation de frittage s'effectuent avec une pression de frittage dans la plage allant de près de 10 à 300 bars.

2. Procédé selon la revendication 1, **caractérisé en ce que** l'on utilise, en guise de mélange pulvérulent, un mélange de Zn et Sb, de Pb et Te, de Bi et Te, d'Ag, Pb, Sb et Te ou de Pb, Te et Se.

3. Procédé selon l'une des revendications précédentes, **caractérisé en ce que** le frittage ou la fixation de frittage est effectué(e) à une température de frittage inférieure à la température de fusion du matériau des éléments Peltier (4), par exemple à une température de frittage supérieure à 100°C et de près de 30 à 50°C inférieure à la température de fusion du matériau des éléments Peltier.

4. Procédé selon l'une des revendications 1 à 3, **caractérisé en ce que** la fixation de frittage a lieu au cours d'une autre étape du procédé en utilisant un matériau de frittage métallique, par exemple en utilisant du cuivre, de l'argent et/ou un alliage de cuivre et d'argent.

5. Procédé selon l'une des revendications 1 à 4, **caractérisé en ce que** le matériau de frittage pour la fixation de frittage est appliqué avec une épaisseur dans la plage comprise entre 10-200 *µ*m.

6. Procédé selon la revendication 4 ou 5, **caractérisé en ce que** l'on utilise, en guise de matériau de frittage métallique, un matériau sous la forme d'une poudre, de préférence sous la forme d'une dispersion ou pâte contenant le matériau de frittage sous forme de poudre ou sous forme de nano-dispersant, et/ou un matériau avec des adjuvants, en particulier avec des adjuvants réduisant la température de frittage et/ou la pression de frittage, par exemple de l'étain.

7. Procédé selon l'une des revendications précédentes, **caractérisé en ce que** la fixation de frittage a lieu directement sur les zones métalliques (9) formant les surfaces de contact (3).

8. Procédé selon l'une des revendications précédentes, **caractérisé en ce que**, avant la fixation de frittage, les zones métalliques (9) formant les surfaces de contact (3) et/ou les éléments Peltier (4) sont muni(e)s, sur leurs côtés de raccordement libres, d'au moins une couche intermédiaire (13, 14, 16, 17) en métal, par exemple une couche intermédiaire en nickel et/ou argent et/ou or, la couche intermédiaire étant par exemple réalisée par dépôt galvanique et/ou chimique et/ou par application du matériau formant la couche intermédiaire au moyen d'une pâte ou d'un dispersion, par exemple d'une nano-dispersion.

9. Procédé selon l'une des revendications précédentes, **caractérisé en ce que** l'on utilise, en guise de substrat en céramique (2), un substrat en céramique fabriqué en oxyde d'aluminium, un substrat en céramique fabriqué en oxyde d'aluminium avec des adjuvants d'oxyde de zirconium, un substrat en céramique fabriqué en nitrure d'aluminium ou un substrat en céramique fabriqué en nitrure de silicium.

10. Procédé selon l'une des revendications précédentes, **caractérisé en ce que** les zones métalliques (9) formant les surfaces de contact (3) sont réalisées en appliquant et structurant une métallisation, par exemple sous la forme d'une pellicule en métal ou en cuivre, l'application de la pellicule en métal ou en cuivre formant la métallisation ayant lieu par exemple en utilisant le procédé de liaison directe ou de brasage actif.
